# EUROPEAN PATENT SPECIFICATION

(11) **EP 3 905 424 B1**
(45) Date of publication and mention of the grant of the patent: **13.03.2024**
(21) Application number: 19904057.7
(22) Date of filing: 20.12.2019
(51) Int. Cl.: G06N 3/04, H01M 10/48, H02J 7/00, G01R 31/392, G01R 31/396, H01M 6/50, G06N 3/08

(54) **DATA PROCESSING DEVICE, DATA PROCESSING METHOD AND COMPUTER PROGRAM**
DATENVERARBEITUNGSVORRICHTUNG, DATENVERARBEITUNGSVERFAHREN UND COMPUTERPROGRAMM
DISPOSITIF DE TRAITEMENT DE DONNÉES, PROCÉDÉ DE TRAITEMENT DE DONNÉES ET PROGRAMME INFORMATIQUE

(30) Priority: 28.12.2018 JP 2018248108
(43) Date of publication of application: 03.11.2021
(73) Proprietor: GS Yuasa International Ltd., Kisshoin, Minami-ku, Kyoto-shi, Kyoto 601-8520 (JP); NTT Communications Corporation, Tokyo 100-8019 (JP)
(72) Inventor: KURISAWA, Isamu, Kyoto-shi, Kyoto 601-8520 (JP); UCHIHORI, Tomikatsu, Kyoto-shi, Kyoto 601-8520 (JP); YAMASAKI, Kayo, Kyoto-shi, Kyoto 601-8520 (JP); MATSUSHIMA, Hitoshi, Kyoto-shi, Kyoto 601-8520 (JP); KIRITOSHI, Keisuke, Tokyo 100-8019 (JP); ITO, Koji, Tokyo 100-8019 (JP)
(74) Representative: Grünecker Patent- und Rechtsanwälte PartG mbB
(86) International application number: PCT/JP2019/050183
(87) International publication number: WO 2020/137914

(56) References cited:
- WO-A1-2012/165629
- WO-A1-2015/198631
- WO-A1-2018/203170
- JP-A- H09 243 716
- JP-A- 2003 249 271
- JP-A- 2010 519 691
- JP-A- 2016 090 346
- JP-A- 2017 004 955
- JP-A- 2019 158 666
- LEI REN ET AL: "Remaining Useful Life Prediction for Lithium-Ion Battery: A Deep Learning Approach", IEEE ACCESS, vol. 6, 8 October 2018 (2018-10-08), pages 50587-50598, XP055526380, DOI: 10.1109/ACCESS.2018.2858856
- DING YU ET AL: "Li-ion Battery Health Estimation Based on Multi-layer Characteristic Fusion and Deep Learning", 2017 IEEE VEHICLE POWER AND PROPULSION CONFERENCE (VPPC), IEEE, 11 December 2017 (2017-12-11), pages 1-5, XP033344320, DOI: 10.1109/VPPC.2017.8331058 [retrieved on 2018-04-03]
- VATANI MOHSEN ET AL: "Cycling Lifetime Prediction Model for Lithium-ion Batteries Based on Artificial Neural Networks", 2018 IEEE PES INNOVATIVE SMART GRID TECHNOLOGIES CONFERENCE EUROPE (ISGT-EUROPE), IEEE, 21 October 2018 (2018-10-21), pages 1-6, XP033472049, DOI: 10.1109/ISGTEUROPE.2018.8571814 [retrieved on 2018-12-10]

## Description

### [Technical Field]

The present invention relates to a data processing apparatus that performs computation using measured data associated with a group of energy storage devices, a data processing method and a computer program.

### [Background Art]

An energy storage device has a wide range of application in an uninterruptible power supply apparatus, a direct or alternate current power supply device included in a stabilized power supply, or the like. Moreover, the use of an energy storage device in a large-scale system for storing renewable energy or power generated in the existing electric generating system has been increased.

In the system employing the energy storage device, maintenance activities are critical including implementation of the diagnosis of a state of the energy storage device, the estimation of a state of charge (SOC), the prediction of a lifetime or the like. As to the method of the diagnosis or estimation of a state of the energy storage device or the prediction of a lifetime of the energy storage device, there have been proposed variable methods starting with a method of using measured data of voltage, current, temperature or the like measured at the time of charge or discharge of the energy storage device, with a view to improving the accuracy (e.g., Patent Document 1 identified in §0004 below). LEI REN ET AL: "Remaining Useful Life Prediction for Lithium-Ion Battery: A Deep Learning Approach", IEEE ACCESS, vol. 6, 8 October 2018 (2018-10-08), pages 50587-50598, DOI: 10.1109/ACCESS.2018.2858856 describes an accurate prediction of Remaining Useful Life (RUL) of lithium-ion battery that plays an increasingly crucial role in the intelligent battery health management systems. The advances in Deep Learning introduce new data-driven approaches to this problem. This paper proposes an integrated deep learning approach for RUL prediction of lithium-ion battery by integrating autoencoder with Deep Neural Network (DNN). Firstly, we present a multi-dimensional feature extraction method with autoencoder model to represent battery health degradation. Then, the RUL prediction model based DNN is trained for multi-battery remaining cycle life estimation. The proposed approach is applied to the real dataset of lithium-ion battery cycle life from NASA, and the experiment results show that the proposed approach can improve the accuracy of RUL prediction. DING YU ET AL: "Li-ion Battery Health Estimation Based on Multi-layer Characteristic Fusion and Deep Learning", 2017 IEEE VEHICLE POWER AND PROPULSION CONFERENCE (VPPC), IEEE,11 December 2017 (2017-12-11), pages 1-5, DOl: 10.1109/VPPC.2017.8331058 relates to existing methods for estimating lithium-ion (Li-ion) battery capacity fading which mostly depend on a priori knowledge on aging mechanism and on the use of chemical or physical formulation and analytical battery models. This dependence is usually difficult to determine in practice, which restricts the application of these methods. In this study, we propose a new method for Li-ion battery health assessment based on multi-layer characteristic integration and deep learning. The proposed method realizes multi-layer characteristic fusion (charge current, discharge voltage, charge time under constant voltage etc.) of relative input parameters by unsupervised self-learning both in the data-layer and the feature-layer, in which the effect of multi-feature fusion can be improved by refactoring learning. Based on the feature extracted by the fusion of multi-layer self-learning, the health assessment of Li-ion battery under multi-feature fusion can be realized using the logistic regression model. Experiments are implemented based on data provided by the NASA Ames Prognostics Center of Excellence. Results confirm that the proposed estimation method performs well by comparing the actual trend results of battery capacity fading.

### [Prior Art Document]

### [Patent Document]

[Patent Document 1] Japanese Patent Application Laid-Open No. 2013-003115

### [Summary of Invention]

### [Problems to be Solved by Invention]

The method of the diagnosis or estimation of a state of the energy storage device or the prediction of a lifetime of the energy storage device as described above is established based on an energy storage device model assumed at the time of manufacture. There, however, are variations in the property of the material and manufacture variations among individual energy storage devices, which causes oddity that deviates from the property of the energy storage device model over the passage of time or depending on the service condition. For example, even if an energy storage device has a similar property to another energy storage device at a time of manufacture, it may last, much longer or shorter than the expected model does. The energy storage device has a property of a decreasing full charge capacity due to repetitive charge and discharge. If a new energy storage device or an energy storage device having a different charge-discharge history is added to a group of energy storage devices having a similar charge-discharge history during the same period, the new or the different energy storage device is odd in the group of the energy storage devices. The magnification of oddity quantitatively represented by a determination model is called the degree of oddity.

In the case where the diagnosis or estimation of a state or the predication of a lifetime is performed on the entire system in which enormous numbers of energy storage devices are connected and used, or in the case where the measured data of an odd energy storage device is included in the measured data of the group of energy storage devices, errors in the diagnosis, estimation or prediction increase.

An object of the present invention is to provide a data processing device that improves the accuracy of diagnosis, estimation and prediction related to an energy storage device based on measured data of the energy storage device, a data processing method and a non-transitory computer-readable medium storing a computer program.

### [Means for Solving Problems]

A data processing device for processing measured data of a plurality of energy storage devices is provided in accordance with claim 1.

### [Brief Description of Drawings]

FIG. 1 illustrates the outline of a remote monitoring system.
FIG. 2 illustrates one example of a hierarchical structure of a group of energy storage modules and a connection pattern of a communication device.
FIG. 3 is a block diagram illustrating the internal configuration of the devices included in the remote monitoring system.
FIG. 4 is a block diagram illustrating the internal configuration of the devices included in the remote monitoring system.
FIG. 5 is a flowchart showing one example of processing for determining an odd energy storage cell.
FIG. 6 is a schematic diagram illustrating one example of a determination model.
FIG. 7 is a flowchart showing one example of a training method of the determination model.
FIG. 8 illustrates one example of smoothing processing.
FIG. 9 is a schematic diagram illustrating another example of the determination model.
FIG. 10 is a schematic diagram illustrating another example of the determination model.

### [Mode for Carrying out Invention]

A data processing device for processing measured data of a plurality of energy storage devices is provided in accordance with claim 1.

If the measured data of the odd energy storage device is input to the autoencoder that has already been trained by the measured data of the energy storage devices not being odd, the error between the input measured data and the reproduced measured data output by the autoencoder is large. Thus, by using the difference as a degree of oddity, whether or not an odd energy storage device is included can be determined.

The determination model may be trained for each season or for each surrounding environment. The surrounding environment may include, for example, the geographical conditions such as temperature, humidity, duration of sunshine or the like and the type of the power generation system as a source of the electric power supply. The determination model may be retrained based on the time since the start of the use of the energy storage devices.

If that a predetermined ratio of data out of the measured data for the energy storage devices is determined to be measured data including odd energy storage device by the determination model rapidly increases, it is presumed that the measured data of the energy storage devices varies as a whole in accordance with the change in the surrounding environment. As the measured data of the energy storage devices varies as a whole, the determination model may also be retrained.

The measured data to be input to the determination model is preferably used after being subjected to smoothing processing such as taking the moving average of the time series data or the like. This prevents erroneous determination even if missing measured data occurs.

A data processing method for processing measured data for an energy storage devices is provided in accordance with claim 6.

A computer program causing a computer to execute processing in accordance with claim 7 is provided.

The present invention will be described below with reference to the drawings.

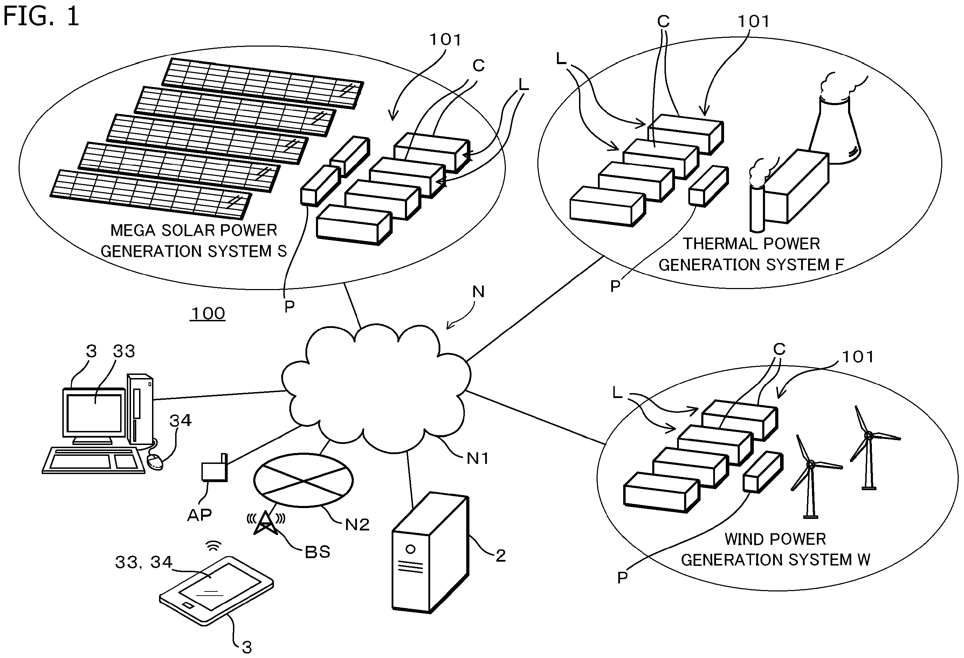

FIG. 1 illustrates the outline of a remote monitoring system 100. The remote monitoring system 100 enables remote access to data on an energy storage device in a group of energy storage devices included in a mega solar power generation system S, a thermal power generation system F and a wind power generation system W.

The mega solar power generation system S, the thermal power generation system F and the wind power generation system W each include a power conditioner (PCS: power conditioning system) and an energy storage system 101 that are installed together. The energy storage system 101 is composed of multiple containers C, which are installed together, each accommodating a group of energy storage modules L. Each of the groups of the energy storage modules L each include multiple energy storage devices. The energy storage device is preferably rechargeable one such as a secondary battery including a lead storage battery, a lithium ion battery or a capacitor. A part of the energy storage device may be a unrechargeable primary battery.

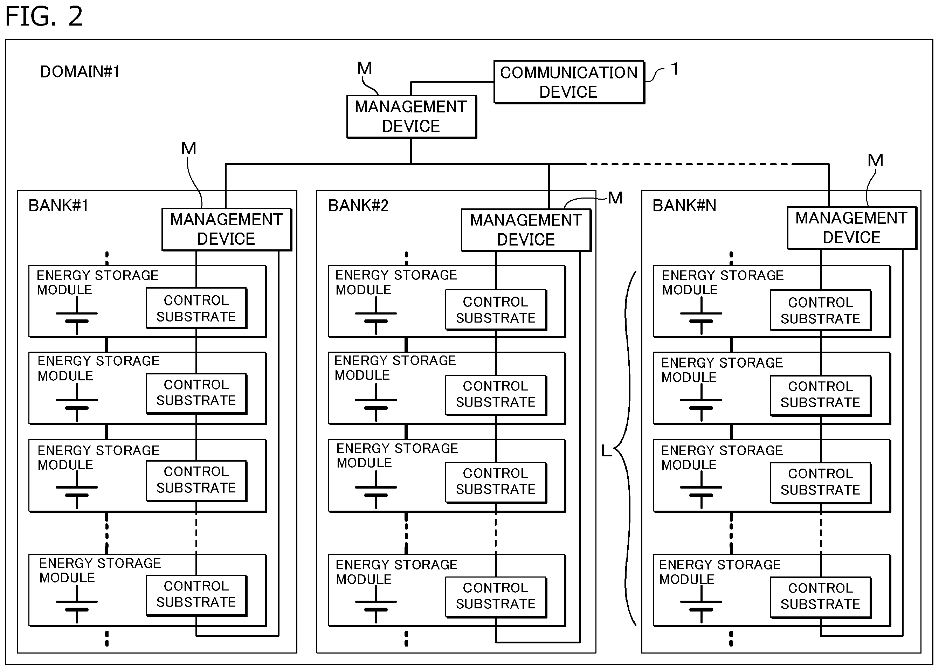

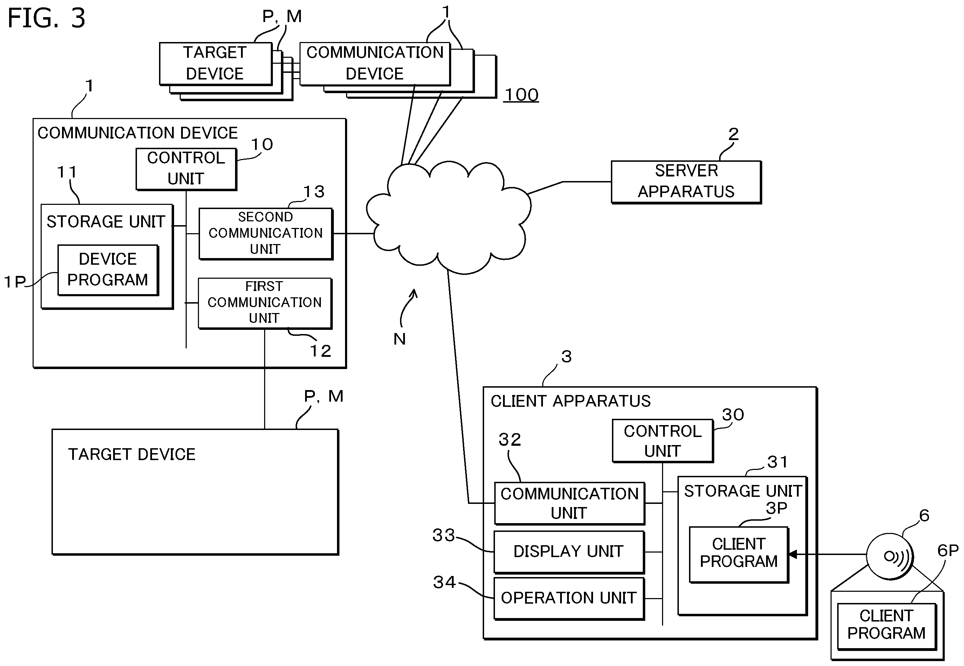

In the remote monitoring system 100, the energy storage systems 101 or devices (P and a management device M to be described later) in the power generation system S, F, W as a target to be monitored is mounted with or connected to a communication device 1 (see FIGs. 2 and 3). The remote monitoring system 100 includes the communication device 1, a server apparatus 2 (data processing apparatus) for collecting data from the communication device 1, a client apparatus 3 for viewing collected data and a network N as a communication medium between the devices.

The communication device 1 may be a terminal device (measurement monitor) that communicates with a battery management device (BMU: battery management unit) contained in the energy storage device to receive data on the energy storage device or may be a controller compliant with ECHONET/ECHONETLite (registered trademark). The communication device 1 may be an independent device or a network card-shaped device that can be mounted on the power conditioner P or the groups of the energy storage modules L. The communication device 1 is provided for each group composed of multiple energy storage modules in order to acquire data on the groups of the energy storage modules L in the energy storage system 101. Multiple power conditioners P are connected to make a serial communication with each other, and the communication device 1 is connected to the control unit of any representative power conditioner P.

The server apparatus 2 performs a Web server function and presents the data acquired from the communication devices 1 mounted with or connected to the devices to be monitored in response to access from the client apparatus 3.

The network N includes a public communication network N1, which is the so-called Internet, and a carrier network N2 that achieves a wireless communication compliant with a predetermined mobile communication standard. The public communication network N1 includes a general optical network. The network N also includes a dedicated line to which the server apparatus 2 is to be connected. The network N may include a network compliant with the ECHONET/ECHONETLite. The carrier network N2 includes a base station BS, and thus the client apparatus 3 can communicate with the server apparatus 2 via the base station BS over the network N. The public communication network N1 is connected to an access point AP, and thus the client apparatus 3 can transmit and receive data to/from the server apparatus 2 via the access point AP over the network N.

The groups of the energy storage modules L of the energy storage system 101 has a hierarchical structure. FIG. 2 illustrates one example of a hierarchical structure of the groups of the energy storage modules L and a connection pattern of the communication device 1. The communication device 1 for transmitting data on the energy storage device to the server apparatus 2 acquires data on a group of energy storage modules L from the management device M provided for each group of the energy storage modules L. The groups of the energy storage modules L hierarchically include, for example, an energy storage module (also called a module) composed of multiple energy storage devices (also called an energy storage cell or cell, where each energy storage device may include multiple electrodes (elements)) connected in series; a bank composed of multiple energy storage modules connected in series; and a domain composed of multiple banks connected in parallel. In the example in FIG 2, the management device M is provided for each bank with the number (#) 1-N while the management device is also provided for each domain in which the banks are connected in parallel. The management device M provided for each bank makes serial communication with a control substrate (CMU: cell monitoring unit) having a communication function that is integrated in each energy storage module and acquires measured data (voltage, current, temperature or the like) for the energy storage cell in the energy storage module. The management device M for each bank performs balance adjustment for each bank based on the measured data acquired per energy storage cells and executes management processing such as detection of an abnormality of a communication state or the like. The management devices M for respective banks transmit measured data acquired from the energy storage modules of the banks to the management device M provided for each domain. The management device M for each bank transmits the state of a balance adjustment of the energy storage modules to the management device M for the domain and makes a report to the management device M for the domain if an abnormality is detected. The management device M for the domain compiles data such as measured data acquired from the management devices M of the banks belonging to the domain, detected abnormality, etc. In the example in FIG. 2, the communication device 1 is connected to the management device M provided for each domain.

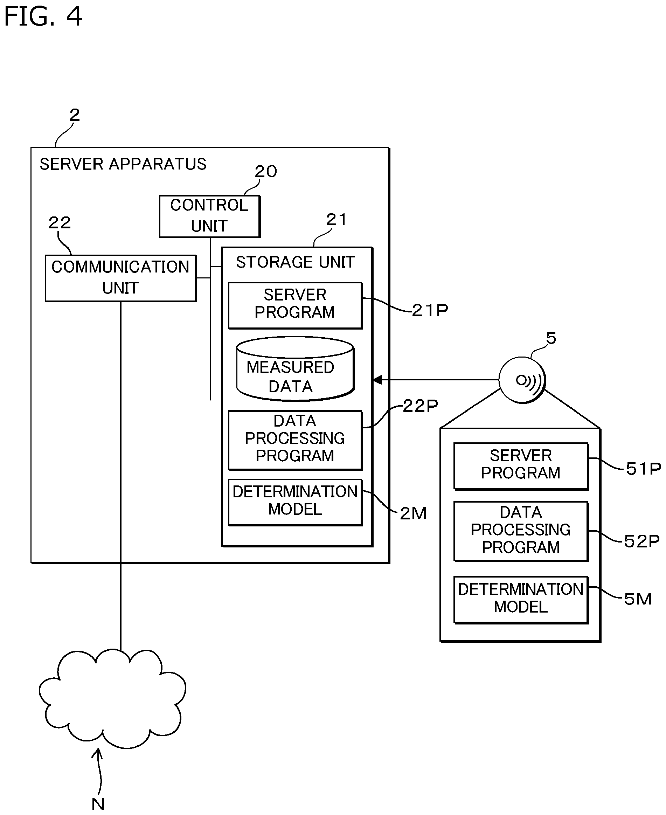

FIGs. 3 and 4 are each a block diagram illustrating the internal configuration of the devices included in the remote monitoring system 100. As illustrated in FIG. 3, the communication device 1 is provided with a control unit 10, a storage unit 11, a first communication unit 12 and a second communication unit 13. The control unit 10 is a processor using a central processing unit (CPU) and executes processing while controlling the components by using a memory such as an integrated read only memory (ROM), an integrated random access memory (RAM) or the like.

The storage unit 11 uses a nonvolatile memory such as a flash memory or the like. The storage unit 11 stores a device program that is to be read and executed by the control unit 10. The device program 1P includes a communication program in conformance with the secure shell (SSH), the simple network management protocol (SNMP) or the like. The storage unit 11 stores data collected by the processing performed by the control unit 10, data on event logs or the like. The data stored in the storage unit 11 can be read via a communication interface such as an USB or the like for which the terminal of the housing of the communication device 1 is exposed.

The first communication unit 12 is a communication interface that achieves communication with a target device to be monitored to which the communication device 1 is connected. The first communication unit 12 employs a serial communication interface, for example, RS-232C, RS-485 or the like. The power conditioner P, for example, is provided with a control unit having a serial communication function in conformance with RS-485, and the first communication unit 12 communicates with this control unit. If the control substrates provided in the groups of the energy storage modules L are connected to a controller area network (CAN) bus to achieve the CAN communication between the control substrates, the first communication unit 12 is a communication interface based on the CAN protocol. The first communication unit 12 may be a communication interface that conforms to the ECHONET/ECHONETLite.

The second communication unit 13 is an interface that achieves communication over the network N and employs a communication interface, for example, the Ethernet (registered trademark), an antenna for wireless communication or the like. The control unit 10 can communicably connect to the server apparatus 2 via the second communication unit 13. The second communication unit 13 may be a communication interface that conforms to the ECHONET/ECHONETLite standard.

In the communication device 1 thus configured, the control unit 10 acquires measured data for the energy storage devices obtained from the devices to which the communication device 1 is connected via the first communication unit 12. The control unit 10 reads and executes the SNMP program to function as an SNMP agent and can respond to an information request from the server apparatus 2.

The client apparatus 3 is a computer to be used by an operator such as an administrator, a maintenance staff or the like of the energy storage system 101 of the energy generation system S, F, W. The client apparatus 3 may be a desktop or laptop personal computer or may be a so-called smart phone or a tablet communication terminal. The client apparatus 3 is provided with a control unit 30, a storage unit 31, a communication unit 32, a display unit 33 and an operation unit 34.

The control unit 30 is a processor using a CPU. The control unit 30 causes the display unit 33 to display a Web page provided by the server apparatus 2 or the communication device 1 based on a client program 3P including a Web browser stored in the storage unit 31.

The storage unit 31 employs a nonvolatile memory, for example, a hard disk, a flash memory or the like. The storage unit 31 stores various programs including the client program 3P. The client program 3P may be obtained by reading a client program 6P stored in the recording medium 6 and storing the copy thereof in the storage unit 31.

The communication unit 32 employs a communication device such as a network card for wired communication, a wireless communication device for mobile communication to be connected to the base station BS (see FIG. 1) or a wireless communication device complying with connection to the access point AP. The control unit 30 can communicably connect to or transmit and receive information to/from the server apparatus 2 or the communication device 1 over the network N by the communication unit 32.

The display unit 33 employs a display such as a liquid crystal display, an organic electro luminescence (EL) display or the like. The display unit 33 displays an image of the Web page provided by the server apparatus 2 by the processing based on the client program 3P performed by the control unit 30. The display unit 33 is preferably a touch panel integrated display but may be a display that is not integrated with a touch panel.

The operation unit 34 is a user interface such as a keyboard and a pointing device that are able to input and output to/from the control unit 30, a voice input unit or the like. The operation unit 34 may use a touch panel of the display unit 33 or a physical button mounted on the housing. The operation unit 34 reports operation data performed by the user to the control unit 20.

As illustrated in FIG. 4, the server apparatus 2 employs a server computer and is provided with a control unit 20, a storage unit 21 and a communication unit 22. In the present embodiment, the server apparatus 2 is described as a single server computer, though multiple server computers may be used to distribute processing.

The control unit 20 is a processor employing a CPU or a graphics processing unit (GPU) and executes processing while controlling the components by using a memory such as an integrated ROM, RAM or the like. The control unit 20 executes communication and data processing based on a server program 21P stored in the storage unit 21. The server program 21P includes a Web server program, and thus the control unit 20 functions as a Web server to execute provision of a Web page to the client apparatus 3. The control unit 20 collects data from the communication device 1 as a SNMP server based on the server program 21P. The control unit 20 executes data processing on the measured data collected based on a data processing program 22P stored in the storage unit 21.

The storage unit 21 employs a nonvolatile memory, for example, a hard disk, a flash memory or the like. The storage unit 21 stores the server program 21P and data processing program 22P as described above. The storage unit 21 stores a determination model 2M to be used for the processing based on the data processing program 22P. The storage unit 21 stores the measured data of the power conditioner P and the group of the energy storage modules L of the energy storage system 101 as a target to be monitored that are collected by the processing performed by the control unit 20.

The server program 21P, the data processing program 22P and the determination model 2M that are stored in the storage unit 21 may be ones obtained by respectively reading a server program 51P, a data processing program 52P and a determination model 5M that are stored in a recording medium 5 and copying them in the storage unit 21.

The communication unit 22 is a communication device that achieves communicable connection and transmission and reception of information over the network N. More specifically, the communication unit 22 is a network card corresponding to the network N.

In the remote monitoring system 100 thus configured, the communication device 1 transmits measured data for each energy storage cell that has been acquired from the management device M and stored after the previous timing and another data to the server apparatus 2 every predetermined timing (for example, every cycle or every time data amount satisfies a predetermined condition). The communication device 1 transmits the measured data in association with the identification information (number) of the energy storage cell. The communication device 1 may transmit all the sampling data obtained via the management device M, may transmit measured data reduced at a predetermined ratio, or may transmit the average value. The server apparatus 2 acquires data including the measured data from the communication device 1 and stores in the storage unit 21 the acquired measured data in association with the acquisition time information and the information identifying the device (M, P) from which the data is acquired.

The server apparatus 2 can present the latest data out of the stored measured data in response to access from the client apparatus 3 for each energy storage cell of the energy storage system 101. The server apparatus 2 can also present a bank-based state or a domain-based state for each energy storage module by using the measured data for energy storage cell. The server apparatus 2 can conduct an abnormality diagnosis and a health examination of the energy storage system 101, estimation of the SOC, the state of health (SOH) or the like of the energy storage module or lifetime prediction thereof by using the measured data based on the data processing program 22P and can present the conduction result.

The server apparatus 2 in the present disclosure determines measured data of an odd energy storage cell from the measured data of the energy storage cells based on the data processing program 22P and the determination model 2M when performing the processing of the above-described diagnosis, estimation or prediction. The server apparatus 2 can accurately perform processing of diagnosis, estimation or prediction based on the energy storage device model assumed at the time of manufacture for each energy storage module, each bank or each domain by using the measured data other than the determined measured data.

A method of determining measured data of an odd energy storage cell performed by the control unit 20 of the server apparatus 2 will be described in detail.

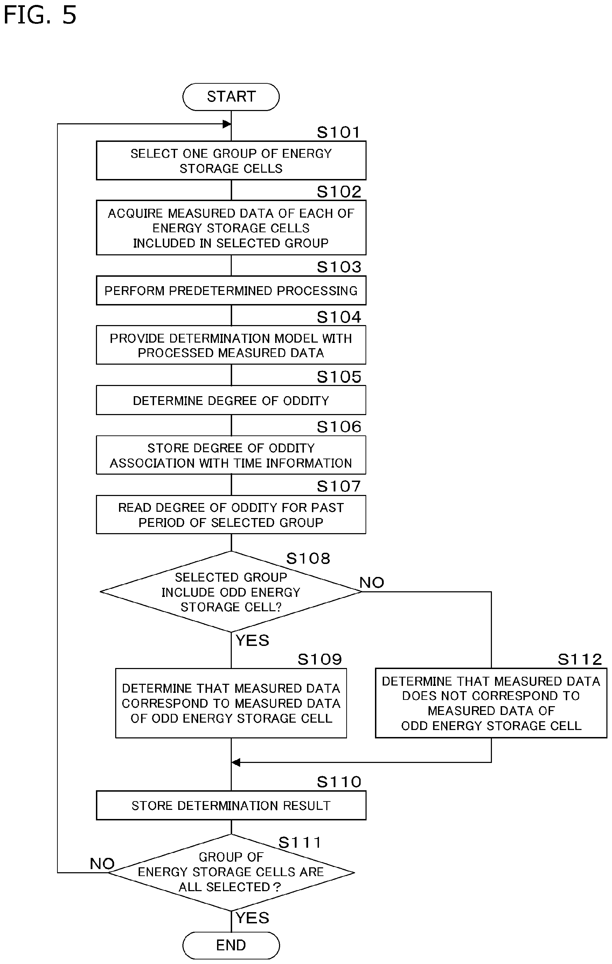

FIG. 5 is a flowchart showing one example of processing for determining an odd energy storage cell. The control unit 20 repeatedly executes determination of the measured data of an odd energy storage cell by using the flowchart in FIG. 5 every acquisition timing of the measured data or every cycle longer than the acquisition cycle.

The control unit 20 selects one group of energy storage cells (step S101). At step S101, the control unit 20 selects energy storage cells by a module as one example, that is, selects identification information of the module. The control unit 20 may select energy storage cells by a bank. In another example, the control unit 20 may select energy storage cells one by one.

The control unit 20 acquires measured data for each of the energy storage cells included in the group of energy storage cells selected at step S101 (step S102). The measured data acquired at step S102 is different depending on a training method of the determination model 2M to be described later.

The control unit 20 performs predetermined processing such as smoothing, normalization or the like depending on the measured data acquired at step S102 (step S103), provides the determination model 2M with the processed measured data (step S104) and determines the degree of oddity output from the determination model 2M (step S105).

The control unit 20 stores in the storage unit 21 the degree of oddity determined at step S105 in association with the information for identifying the group of the energy storage cells selected at step S101 and the time information of the acquired measured data (step S106).

The control unit 20 reads the degree of oddity for the past predetermined period stored in the storage unit 21 for the group of the energy storage cells selected at step S101 (step S107). The control unit 20 determines whether or not the group of the energy storage cells selected at step S101 includes an odd energy storage cell based on the read degree of oddity for the past predetermined period (step S108). At step S108, the control unit 20 performs determination based on a comparison result obtained by comparing the absolute value of the degree of oddity, the variation with time of the degree of oddity or the like with a predetermined comparison value, for example.

If determining that an odd energy storage cell is included at step S108 (S108: YES), the control unit 20 determines that the measured data of the group of the energy storage cells selected at step S101 corresponds to the measured data of an odd energy storage cell (step S109). The control unit 20 stores in the storage unit 21 the determination result in association with the identification information and the time information of the group of the energy storage cells (step S110) and determines whether or not the group of the energy storage cells are all selected at step S101 (step S111).

If determining that the group of the energy storage cells are all selected at step S111 (S111: YES), the control unit 20 ends the determination processing of the measured data of an odd energy storage cell.

If determining that an odd energy storage cell is not included at step S108 (S108: NO), the control unit 20 determines that the measured data of the group of the energy storage cells does not correspond to the measured data of an odd energy storage cell (step S112) and advances the processing to step S110.

If determining that the groups of the energy storage cells are not all selected at step S111 (S111: NO), the control unit 20 returns the processing to step S101 to select a next group (S101).

According to the flowchart in FIG. 5, the control unit 20 determines whether or not an odd energy storage cell is included by the module in which the energy storage cells are connected in series. Though the unit of the energy storage cells to be determined is not limited to the module basis, it may be decided depending on the training method of the determination model 2M. For example, the determination may be performed on a bank basis or on an individual energy-storage-cell basis.

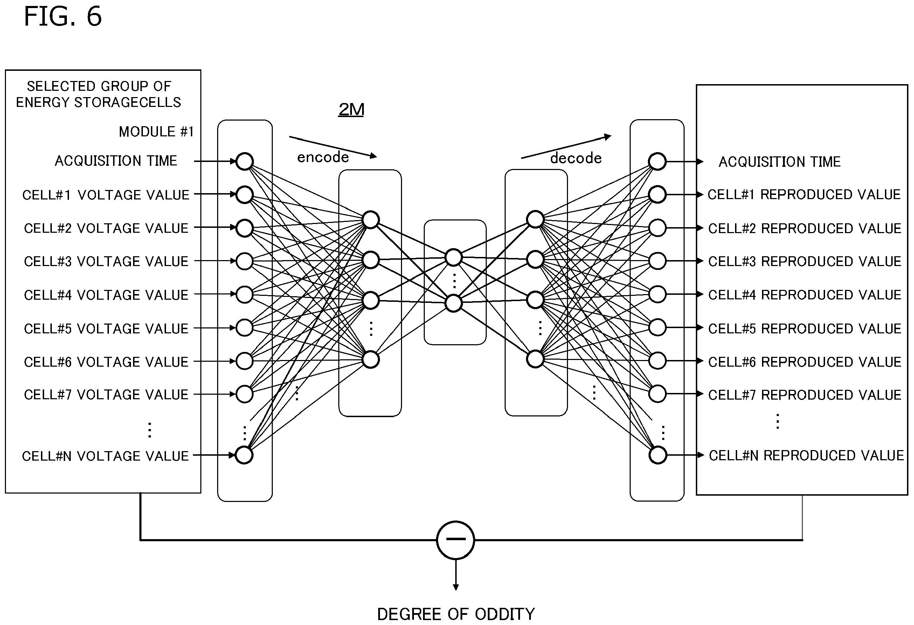

The method of determining the degree of oddity using the determination model 2M will be described. FIG. 6 is a schematic diagram of one example of the determination model 2M. The determination model 2M according to the present embodiment employs an autoencoder in which measured data of the energy storage cells are input and abstracted to reproduce measured data from the abstracted information. The control unit 20 determines the degree of oddity based on the comparison between the measured data input to the determination model 2M and the reproduced measured data. In the example in FIG. 6, the determination model 2M inputs measured data on a module basis. The determination data corresponds to respective voltage values of the multiple energy storage cells included in the module. The determination model 2M is so trained as to abstract (encode) a group of voltage values input by the autoencoder and reproduce (decode) a group of input voltages from the abstracted data. A group of voltage values already known to be not odd are used as teacher data for an input, and learning is performed so as to minimize the difference between the input group of voltages and a group of voltages reproduced. The teacher data is, for example, measured data of energy storage cells of a standard model under the test environment or data obtained by simulation computation.

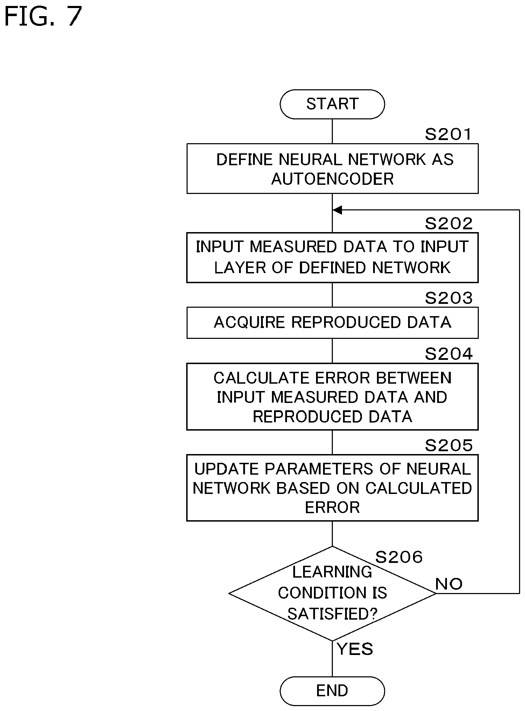

FIG. 7 is a flowchart showing one example of a training method of the determination model 2M. The control unit 20 executes the following learning processing as to the energy storage system 101 initially or periodically to be described later based on the data processing program 22P stored in the storage unit 21. The control unit 20 defines the neural network as an autoencoder based on the definition data of the autoencoder stored in the storage unit 21 (step S201).

The control unit 20 inputs, as teacher data, measured data (a group of voltage values) of the energy storage cells already been known to the input layer of the defined network (step S202) and acquires reproduced data (a group of reproduced values) output from the output layer thereof (step S203). The control unit 20 calculates an error (loss) between the input measured data and the reproduced data (step S204) and updates parameters such as weights or the like in the network based on the calculated error (step S205).

The control unit 20 determines whether or not a predetermined learning condition is satisfied (step S206). If determining that the predetermined learning condition is not satisfied at step S206 (S206: NO), the control unit 20 returns the processing to step S202 to perform learning using another group of voltage values. The "predetermined learning criteria" correspond to whether or not the error calculated at step S204 is reduced, whether or not the number of training data is equal to or more than a predetermined number, or whether or not the number of trainings is equal to or higher than a predetermined number of times, for example.

If determining that the predetermined training condition is satisfied at step S206 (S206: YES), the control unit 20 ends the learning processing. Thus, the neural network is trained as the autoencoder that reproduces a group of voltage values known to be not odd that has already been prepared with the highest accuracy.

The control unit 20 may create the determination model 2M by executing the processing procedure shown by the flowchart in FIG. 7 at a timing when the energy storage system 101 is constructed. When the system S, F, W is built, the control unit 20 executes the processing procedure according to the flowchart in FIG. 7 using as teacher data the measured data actually obtained from the group of energy storage cells newly incorporated on a domain basis or on a bank basis before the practical use thereof. This makes it possible to obtain the determination models 2M suitable for the measured data having a property unique to each of the systems S, F, W. The control unit 20 may retrain the determination model 2M at a timing based on the elapsed time since the start of the practical use. The timing includes, for example, a predetermined cycle or a preset schedule. The control unit 20 may retrain the determination model 2M every time the number of charge and discharge times since the start of the practical use exceeds a predetermined number of times.

The control unit 20 may perform the processing procedure shown in the flowchart in FIG. 7 for each season to thereby create different determination models 2Ma, 2Mb, 2Mc ... depending on the season. In the large-scale energy generation systems S, F, W illustrated in FIG. 1, the groups of energy storage cells are accommodated and used in the container C installed outdoors. The state of the energy storage cells is affected by the temperature inside the container C due to the atmospheric temperature varying depending on the season. Thus, the determination using the determination models 2Ma, 2Mb, 2Mc ... different depending on the season enhances its accuracy. The state of the energy storage cells is affected by electric power demand different depending on the season. During the period (month) of high electronic power demand, the determination model 2M is repeatedly retrained by the measured data to thereby create and use the retrained determination model 2M or different determination models 2Ma, 2Mb, 2Mc ... different for each month.

If the determination model 2M is thus trained for each system or each season, the control unit 20 selects any suitable model from the determination models 2M trained for each system and each season and uses the selected model before executing the processing procedure shown by the flowchart in FIG. 5.

The control unit 20 may retrain the determination model 2M as the system operation progresses. The control unit 20 may retrain the determination model 2M such that all the measured data are regarded as the measured data of the energy storage cells not being odd if the ratio of the odd measured data to the measured data of all the group of energy storage cells determined by the processing procedure shown by the flowchart in FIG. 5 exceeds a predetermined ratio (twenty percent, for example). Thus, as the entire energy storage system 101 including a group of energy storage cells changes with time, the determination model 2M also changes with time, which is expected to prevent an erroneous determination and perform appropriate determination on different odd energy storage cells occurring over time. If the determination model 2M changes with time, the determination model 2M is stored in another nonvolatile storage medium depending on the elapsed years such as one year, two years and the like and may be applied to the time-dependent change of another energy storage system 101.

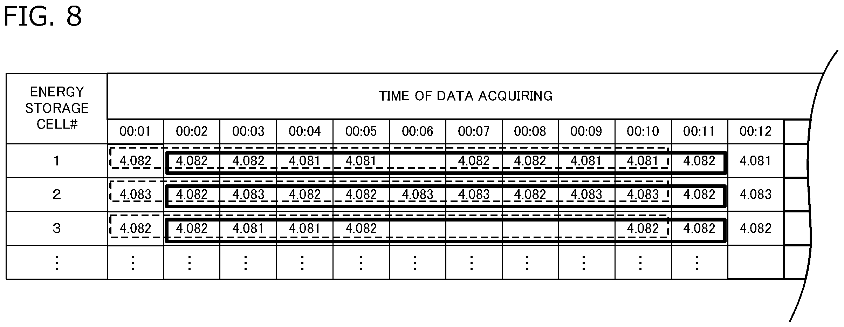

In the case where the voltage values of multiple energy storage cells are input to the determination model 2M illustrated in the example in FIG. 6, the control unit 20 performs smoothing processing by a method of calculating the average value of the voltage values taken during a predetermined time period. FIG. 8 illustrates one example of the smoothing processing. FIG. 8 chronologically shows voltage values measured per minute for each energy storage cell. When inputting the voltage values to the determination model 2M, the control unit 20 inputs the average value of the voltages values taken for the past predetermined period, for example, for the past 10 minutes. The control unit 20 performs smoothing processing of evaluating the average (moving average) of the voltage values taken during the acquisition time periods from 1 minute to 10 minutes indicated by the dashed lines in FIG. 8 and inputs the processed numerical value to the determination model 2M at the time point when data acquisition time 10 minutes (00: 10) has passed. Similarly, the control unit 20 performs smoothing processing of evaluating the average (moving average) of the voltage values taken during the acquisition time period from 2 minutes to 11 minutes indicated by the solid lines in FIG. 8 and inputs the processed numerical value to the determination model 2M at the time point when data acquisition time 11 minutes (00: 11) has passed.

The smoothing processing in FIG. 8 enables accurate determination even if there is missing data in the measured data that can be acquired at the respective time points. For example, the voltage value of the first energy storage cell has a missing voltage value at the time point when data acquisition time of 6 minutes has passed. The voltage value of the third energy storage cell has four missing voltage values at the time points when data acquisition time of 6 to 9 minutes each have passed. If the measured data acquired at each of the time points is input, the zero value, for example, is input as missing data, so that the degree of oddity determined to be odd is output from the determination model 2M as a spike. By performing the smoothing processing using the past measured data at respective time points, erroneous determination can be prevented even if data is temporarily missing.

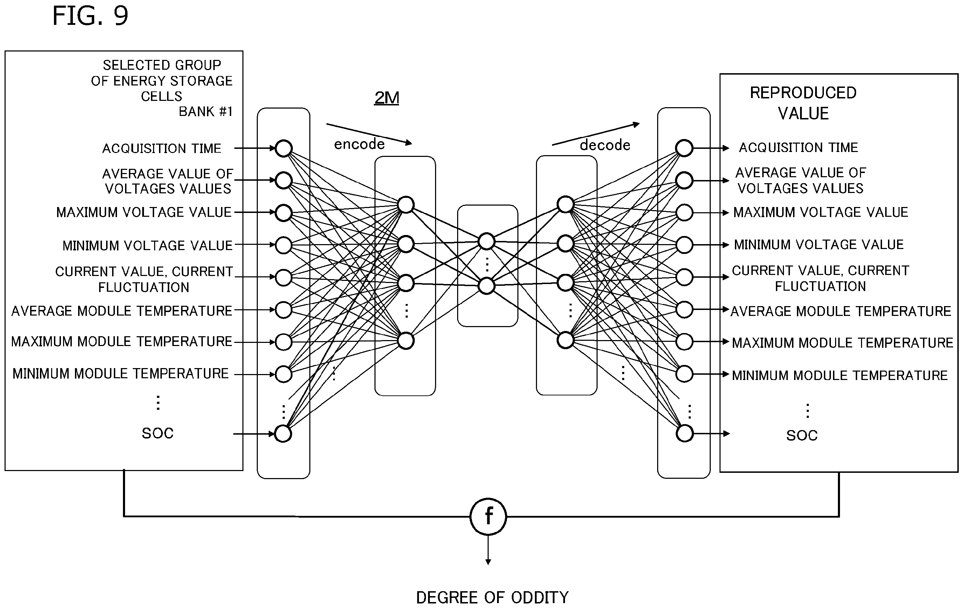

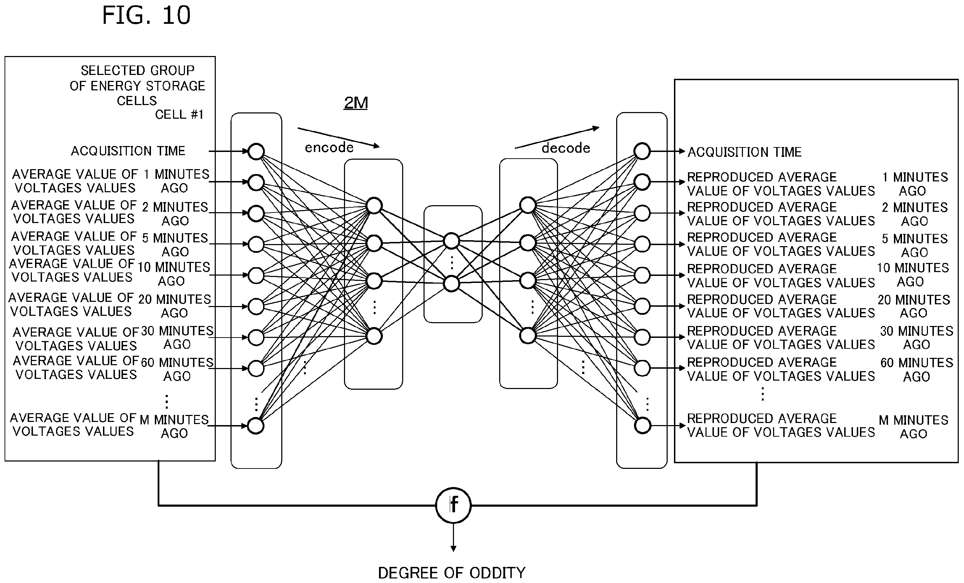

The determination model 2M is not limited to the example in FIG. 6. The determination model 2M may be so trained as to allow the measured data illustrated in FIGs. 9 and 10 below to be input. FIG. 9 is a schematic diagram illustrating another example of the determination model 2M. In the determination model 2M illustrated in the example in FIG. 9, measured data on bank basis is input. The measured data includes the average voltage value, the maximum voltage value, the minimum voltage value and the current value of the energy storage cells included in the bank, the average module temperature, and the maximum module temperature, the minimum module temperature and the SOC calculated from a voltage value and a current value. In this case as well, smoothing processing may be performed including taking the average of the time series data from the past several minutes to several hundreds of minutes. FIG. 10 is a schematic diagram illustrating another example of the determination model 2M. In the determination model 2M illustrated in the example in FIG. 10, measured data per one energy storage cell is input. The time series data obtained by performing smoothing processing in FIG. 8 at the past different time points are input to the determination model 2M. In the determination model 2M in FIGs. 9 and 10, an error between the measured data and the reproduced data may be evaluated by a specific loss function.

The embodiment above described the processing of determining the measured data of an odd energy storage cell by the server apparatus 2 that collects measured data of the group of the energy storage devices. The management device M for the energy storage system 101 having a hierarchical structure from a domain, through banks to modules may execute processing of determining the measured data of the odd energy storage cell.

The embodiment above described the processing of the diagnosis of the state, the estimation of deterioration or the predication of a lifetime in the energy storage system 101 including the energy storage devices having a hierarchical structure from a domain to banks. The similar processing can apply to the case where groups of energy storage modules L are connected in parallel in which multiple energy storage devices included in an uninterruptible power supply unit and a rectifier are connected.

## Claims

1. A data processing device (2) for processing measured data of a plurality of energy storage devices, comprising:
a storage unit (21) configured to store a trained determination model (2M), the determination model using an autoencoder, trained to reproduce measured data when measured data is input by using teacher data obtained from standard energy storage devices, the input measured data being of each of the plurality of energy storage devices or of each group of energy storage devices, grouped from the plurality of energy storage devices; and
a processor (20) in communication with the storage unit, **characterized in that** the processor is configured to:
apply the trained determination model to determine (S108) if the plurality of energy storage devices includes an odd storage device based on an error between reproduced measured data, wherein the error is output when the measured data or for each of energy storage devices or for each group of energy storage devices is input to the trained determination model (2M), and
in case that an odd energy storage device is included, determine (S109) that the measured data is corresponding to measured data of an odd energy storage device out of the measured data for each of the energy storage devices or for each group of energy storage devices.

2. The data processing device according to claim 1, wherein
the determination model is composed of a plurality of determination models,
the plurality of determination models are separately trained by measured data for an energy storage device not being odd that are measured depending on a season or depending on classification of a surrounding environment of the plurality of energy storage devices, and
the processor selects one of the plurality of determination models depending on a period of measured data or depending on the classification and inputs the measured data to the selected one of the plurality of determination models.

3. The data processing device according to claim 1 or 2, wherein the determination model is retrained at a timing based on an elapsed time since a start of use of the energy storage devices.

4. The data processing device according to any one of claims 1 to 3, wherein
the determination model is retrained by using all sets of measured data, if a predetermined ratio of the sets of measured data for each of the plurality of energy storage devices or each group of energy storage devices included in the plurality of energy storage devices is determined as measured data of an odd energy storage device.

5. The data processing device according to any one of claims 1 to 4, wherein the processor performs smoothing processing on measured data before the measured data is input to the determination model and inputs measured data after the smoothing processing.

6. A data processing method for processing measured data for a plurality of energy storage devices, the method performed on a data processing device (2) that comprises a storage unit (21) and a processor (20) in communication with the storage unit, the method comprising:
storing a trained determination model (2M), the determination model using an autoencoder trained to reproduce measured data when measured data is input by using teacher data obtained from standard energy storage devices, the measured data being of each of the plurality energy storage devices or of each group of energy storage devices grouped from the plurality of the energy storage devices;
**characterized by**:
applying the trained determination model for determining if the plurality of energy storage devices includes an odd energy storage device based on an error between reproduced measured data, wherein the error is output when the measured data for each of energy storage devices or for each group of energy storage devices is input to the trained determination model; and
in case that an odd energy storage device is included, determining that the measured data is corresponding to measured data of an odd energy storage device (S109) out of the measured data for each of the energy storage devices or for each group of energy storage devices.

7. A non-transitory computer-readable medium storing a computer program (22P), the computer program, which when executed by a data processing device (2), comprising
a storage unit (21) and a processor (20) in communication with the storage unit, causes the data processing device to execute the method of claim 6.

## Patentansprüche

1. Datenverarbeitungsvorrichtung (2) zum Verarbeiten von Messdaten einer Vielzahl von Energiespeichereinrichtungen, umfassend:
eine Speichereinheit (21), die konfiguriert ist zum Speichern eines trainierten Bestimmungsmodells (2M), wobei das Bestimmungsmodell einen Autoencoder verwendet, der trainiert ist für das Reproduzieren von Messdaten, wenn Messdaten unter Verwendung von Lehrerdaten, die von Standard-Energiespeichereinrichtungen erhalten werden, eingegeben werden, wobei die eingegebenen Messdaten jeweils von der Vielzahl von Energiespeichereinrichtungen oder von jeweils durch die Vielzahl von Energiespeichereinrichtungen gebildeten Gruppen von Energiespeichereinrichtungen stammen, und
einen Prozessor (20), der mit der Speichereinheit kommuniziert, **dadurch gekennzeichnet, dass** der Prozessor konfiguriert ist zum:
Anwenden des trainierten Bestimmungsmodells für das Bestimmen (S108), ob die Vielzahl von Energiespeichereinrichtungen eine abweichende Speichereinrichtung umfasst, basierend auf einem Fehler zwischen reproduzierten Messdaten, wobei der Fehler ausgebeben wird, wenn die Messdaten für jede Energiespeichereinrichtung oder für jede Gruppe von Energiespeichereinrichtungen in das trainierte Bestimmungsmodell (2M) eingegeben werden, und
falls eine abweichende Energiespeichereinrichtung enthalten ist, Bestimmen (S109), dass die Messdaten Messdaten einer abweichenden Energiespeichereinrichtung innerhalb der Messdaten für jede der Energiespeichereinrichtungen oder jede Gruppe von Energiespeichereinrichtungen entsprechen.

2. Datenverarbeitungsvorrichtung nach Anspruch 1, wobei:
das Bestimmungsmodell aus einer Vielzahl von Bestimmungsmodellen besteht,
die Vielzahl von Bestimmungsmodellen separat durch Messdaten für eine nicht abweichende Energiespeichereinrichtung, die in Abhängigkeit von der Jahreszeit oder in Abhängigkeit von einer Klassifikation einer Umgebung der Vielzahl von Energiespeichereinrichtungen gemessen werden, trainiert werden, und
der Prozessor eines aus der Vielzahl von Bestimmungsmodellen in Abhängigkeit von einer Periode von Messdaten oder in Abhängigkeit von der Klassifikation auswählt und die gemessenen Daten in das ausgewählte aus der Vielzahl von Bestimmungsmodellen eingibt.

3. Datenverarbeitungsvorrichtung nach Anspruch 1 oder 2, wobei das Bestimmungsmodell erneut mit einem Timing basierend auf der seit dem Start der Verwendung der Energiespeichereinrichtungen abgelaufenen Zeit trainiert wird.

4. Datenverarbeitungsvorrichtung nach einem der Ansprüche 1 bis 3, wobei das Bestimmungsmodell erneut unter Verwendung von allen Sätzen von Messdaten trainiert wird, wenn ein vorbestimmtes Verhältnis der Sätze von Messdaten für jede aus der Vielzahl von Energiespeichereinrichtungen oder jede Gruppe von Energiespeichereinrichtungen in der Vielzahl von Energiespeichereinrichtungen als Messdaten einer abweichenden Energiespeichereinrichtung bestimmt wird.

5. Datenverarbeitungsvorrichtung nach einem der Ansprüche 1 bis 4, wobei der Prozessor eine Glättungsverarbeitung auf Messdaten durchführt, bevor die Messdaten in das Bestimmungsmodell eingegeben werden, und Messdaten nach der Glättungsverarbeitung eingibt.

6. Datenverarbeitungsverfahren zum Verarbeiten von Messdaten für eine Vielzahl von Energiespeichereinrichtungen, wobei das Verfahren an einer Datenverarbeitungsvorrichtung (2) durchgeführt wird, die eine Speichereinheit (21) und einen mit der Speichereinheit kommunizierenden Prozessor (20) umfasst, wobei das Verfahren umfasst:
Speichern eines trainierten Bestimmungsmodells (2M), wobei das Bestimmungsmodell einen Autoencoder verwendet, der trainiert ist für das Reproduzieren von Messdaten, wenn Messdaten unter Verwendung von Lehrerdaten, die von Standard-Energiespeichereinrichtungen erhalten werden, eingegeben werden, wobei die eingegebenen Messdaten jeweils von der Vielzahl von Energiespeichereinrichtungen oder von jeweils durch die Vielzahl von Energiespeichereinrichtungen gebildeten Gruppen von Energiespeichereinrichtungen stammen,
**gekennzeichnet durch**:
Anwenden des trainierten Bestimmungsmodells für das Bestimmen, ob die Vielzahl von Energiespeichereinrichtungen eine abweichende Speichereinrichtung umfasst, basierend auf einem Fehler zwischen reproduzierten Messdaten, wobei der Fehler ausgebeben wird, wenn die Messdaten für jede Energiespeichereinrichtung oder für jede Gruppe von Energiespeichereinrichtungen in das trainierte Bestimmungsmodell eingegeben werden, und
falls eine abweichende Energiespeichereinrichtung enthalten ist, Bestimmen (S109), dass die Messdaten Messdaten einer abweichenden Energiespeichereinrichtung innerhalb der Messdaten für jede der Energiespeichereinrichtungen oder jede Gruppe von Energiespeichereinrichtungen entsprechen.

7. Nicht-transitorisches, computerlesbares Medium mit einem darauf gespeicherten Computerprogramm (22P), das bei einer Ausführung durch eine Datenverarbeitungsvorrichtung (2), die eine Speichereinheit (21) und einen mit der Speichereinheit kommunizierenden Prozessor (20) umfasst, die Datenverarbeitungsvorrichtung zum Ausführen des Verfahrens von Anspruch 6 veranlasst.

## Revendications

1. Dispositif de traitement de données (2) pour traiter les données mesurées d'une pluralité de dispositifs de stockage d'énergie, comprenant :
une unité de stockage (21) configurée pour stocker un modèle de détermination développé (2M), le modèle de détermination utilisant un auto-encodeur, développé pour reproduire les données mesurées lorsque les données mesurées sont saisies en utilisant des données d'enseignant obtenues à partir de dispositifs de stockage d'énergie standard, les données mesurées d'entrée étant de chacun de la pluralité de dispositifs de stockage d'énergie ou de chaque groupe de dispositifs de stockage d'énergie, regroupés à partir de la pluralité de dispositifs de stockage d'énergie ; et.
un processeur (20) en communication avec l'unité de stockage, **caractérisé en ce que** le processeur est configuré pour :
appliquer le modèle de détermination développé pour déterminer (S108) si la pluralité de dispositifs de stockage d'énergie comprend un dispositif de stockage impair sur la base d'une erreur entre les données mesurées reproduites, l'erreur étant émise lorsque les données mesurées ou pour chacun des dispositifs de stockage d'énergie ou pour chaque groupe de dispositifs de stockage d'énergie sont entrées dans le modèle de détermination développé (2M), et dans le cas où un dispositif de stockage d'énergie impair est inclus, déterminer (S109) que les données mesurées correspondent à des données mesurées d'un dispositif de stockage d'énergie impair parmi les données mesurées pour chacun des dispositifs de stockage d'énergie ou pour chaque groupe de dispositifs de stockage d'énergie.

2. Dispositif de traitement de données selon la revendication 1,
dans lequel le modèle de détermination est composé d'une pluralité de modèles de détermination,
la pluralité de modèles de détermination est développée séparément par des données mesurées pour un dispositif de stockage d'énergie non impair qui sont mesurées en fonction d'une saison ou en fonction de la classification d'un environnement de la pluralité de dispositifs de stockage d'énergie, et
le processeur sélectionne l'un de la pluralité de modèles de détermination en fonction d'une période de données mesurées ou en fonction de la classification et entre les données mesurées dans l'un des modèles de détermination sélectionné parmi la pluralité de modèles de détermination.

3. Dispositif de traitement de données selon les revendications 1 ou 2,
dans lequel le modèle de détermination est redéveloppé à un moment donné en fonction du temps écoulé depuis un début d'utilisation des dispositifs de stockage d'énergie.

4. Dispositif de traitement de données selon l'une des revendications 1 à 3,
dans lequel le modèle de détermination est redéveloppé en utilisant tous les ensembles de données mesurées, si un rapport prédéterminé des ensembles de données mesurées pour chacun de la pluralité de dispositifs de stockage d'énergie ou chaque groupe de dispositifs de stockage d'énergie inclus dans la pluralité de dispositifs de stockage d'énergie est déterminé comme étant des données mesurées d'un dispositif de stockage d'énergie impair.

5. Dispositif de traitement de données selon l'une des revendications 1 à 4,
dans lequel le processeur effectue un traitement de lissage sur les données mesurées avant que les données mesurées ne soient entrées dans le modèle de détermination et entre les données mesurées après le traitement de lissage.

6. Procédé de traitement de données pour traiter les données mesurées pour une pluralité de dispositifs de stockage d'énergie, le procédé exécuté sur un dispositif de traitement de données (2) qui comprend une unité de stockage (21) et un processeur (20) en communication avec l'unité de stockage, ledit procédé comprenant les opérations suivantes :
stocker un modèle de détermination développé (2M), le modèle de détermination utilisant un auto-encodeur développé pour reproduire les données mesurées lorsque les données mesurées sont entrées en utilisant des données d'enseignant obtenues à partir de dispositifs de stockage d'énergie standard, les données mesurées étant de chacun de la pluralité de dispositifs de stockage d'énergie ou de chaque groupe de dispositifs de stockage d'énergie regroupés à partir de la pluralité des dispositifs de stockage d'énergie ;
**caractérisé par** les opérations suivantes :
appliquer le modèle de détermination développé pour déterminer si la pluralité de dispositifs de stockage d'énergie comprend un dispositif de stockage d'énergie impair sur la base d'une erreur entre les données mesurées reproduites, l'erreur étant émise lorsque les données mesurées pour chacun des dispositifs de stockage d'énergie ou pour chaque groupe de dispositifs de stockage d'énergie sont entrées dans le modèle de détermination développé; et.
au cas où un dispositif de stockage d'énergie impair est inclus, déterminer que les données mesurées correspondent aux données mesurées d'un dispositif de stockage d'énergie impair (S109) parmi les données mesurées pour chacun des dispositifs de stockage d'énergie ou pour chaque groupe de dispositifs de stockage d'énergie.

7. Support non transitoire lisible par ordinateur stockant un programme d'ordinateur (22P), le programme d'ordinateur qui, lorsqu'il est exécuté par un dispositif de traitement de données (2), comprenant une unité de stockage (21) et un processeur (20) en communication avec l'unité de stockage, amène le dispositif de traitement de données à exécuter le procédé de la revendication 6.
